(19) **Europäisches Patentamt / European Patent Office / Office européen des brevets**

(11) **EP 4 764 529 A1**

(12) **EUROPEAN PATENT APPLICATION**
published in accordance with Art. 153(4) EPC

(43) Date of publication:
**24.06.2026 Bulletin 2026/26**

(21) Application number: **25807938.3**

(22) Date of filing: **06.03.2025**

(51) International Patent Classification (IPC):
**G01R 31/374** (2019.01)   **G01R 31/392** (2019.01)
**G01R 31/36** (2020.01)   **G01R 31/3842** (2019.01)
**G01R 31/367** (2019.01)   **G01R 31/396** (2019.01)
**H01M 10/48** (2006.01)   **G01R 31/382** (2019.01)

(52) Cooperative Patent Classification (CPC):
**G01R 31/36; G01R 31/367; G01R 31/374;**
**G01R 31/382; G01R 31/3842; G01R 31/392;**
**G01R 31/396; H01M 10/48**

(86) International application number:
**PCT/KR2025/002967**

(87) International publication number:
**WO 2025/244255 (27.11.2025 Gazette 2025/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.05.2024 KR 20240066780**
**18.10.2024 KR 20240142672**

(71) Applicant: **LG Energy Solution, Ltd.**
**Seoul 07335 (KR)**

(72) Inventors:
• **PARK, Ki Bum**
  **Daejeon 34122 (KR)**
• **BANG, Ji Won**
  **Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT DEVICE AND BATTERY MANAGEMENT METHOD**

(57)    According to some embodiments, a battery management device includes an interface configured to acquire battery data of a battery and a controller configured to calculate a first state of health (SOH) value of the battery based on the battery data, calculate a first SOH correction value for the first SOH value using a regression equation that calculates an SOH correction value based on error factors causing an error in the first SOH value, and calculate a second SOH value by applying the first SOH correction value to the first SOH value.

FIG.2

**Description**

**TECHNICAL FIELD**

**Cross-reference to Related Applications**

This application claims priority from Korean Patent Application Nos. 10-2024-0142672, filed October 18, 2024, and 10-2024-0066780, filed May 22, 2024, the disclosures of which are incorporated by reference herein.

**Technical Field**

Embodiments disclosed herein relate to a battery management device and a battery management method.

**BACKGROUND ART**

In recent years, research and development for secondary batteries have been actively conducted. Here, secondary batteries are batteries capable of being recharged and discharged, and may be interpreted to encompass both conventional Ni/Cd batteries, Ni/MH batteries, or the like, and recent lithium ion batteries. Among secondary batteries, lithium ion batteries may have a higher energy density than conventional Ni/Cd batteries, Ni/MH batteries, or the like, and may be manufactured to be small and lightweight, so the lithium ion batteries may have high usability as a power source for mobile devices. In recent years, the lithium ion batteries have expanded their range of use to power sources for electric vehicles, making the batteries attract attention as a next-generation energy storage medium.

By using the charge current when charging the battery and state of charge (SOC) values before and after charging, a state of health (SOH) value corresponding to the charging of the battery may be calculated. The SOC values used to calculate the SOH values may be derived through a mapping relationship with an open circuit voltage (OCV). When variables such as charging temperature are not considered while calculating the SOH, SOH errors due to temperature differences may occur, and when there is an error in the OCV-SOC mapping relationship itself, errors may also occur in the SOH value.

**DISCLOSURE OF THE INVENTION**

**TECHNICAL PROBLEM**

One of objects of the embodiments disclosed herein is to provide a battery management device and a battery management method capable of estimating a more accurate SOH value by correcting an error that occurs when calculating an SOH value using charge current and charging SOC values.

The technical objectives of the embodiments disclosed herein are not limited to those mentioned above, and other technical objectives not mentioned will be clearly understood by those skilled in the art from the following descriptions.

**TECHNICAL SOLUTION**

According to some embodiments, a battery management device includes an interface configured to acquire battery data of a battery and a controller configured to calculate a first state of health (SOH) value of the battery based on the battery data, calculate a first SOH correction value for the first SOH value using a regression equation that calculates an SOH correction value based on error factors causing an error in the first SOH value, and calculate a second SOH value by applying the first SOH correction value to the first SOH value.

According to some embodiments, the battery data includes charge data that is cumulatively collected each time a charging of the battery satisfies a validity condition, and the controller is configured to calculate the second SOH value based on the charge data.

According to some embodiments, the charge data includes charge open circuit voltage (OCV) data and charge current data of each of valid chargings satisfying the validity condition within a period of interest, and the controller is configured to calculate the first SOH value for each of the valid chargings based on SOC data and the charge current data corresponding to the charge OCV data.

According to some embodiments, the regression coefficients of the regression equation for the error factors are learned to calculate the first SOH correction value based on the first SOH values for the valid chargings.

According to some embodiments, a first SOH deviation value of each of the first SOH values with respect to a representative value of the first SOH values is set as a residual of the regression equation, and the regression coefficients are learned to minimize the residuals of the regression equation.

According to some embodiments, the error factors include at least one of a charging start SOC according to the SOC data, a charging end SOC according to the SOC data, a charging start temperature, and a charging end temperature.

According to some embodiments, the regression equation is constructed based on a multivariate polynomial including terms composed of combinations of the error factors.

According to some embodiments, the controller is configured to calculate the first SOH correction values for the valid chargings by applying the error factors for each of the valid chargings to the regression coefficients of the regression equation after completion of learning.

According to some embodiments, the validity condition includes a first condition regarding whether a charge amount exceeds a threshold amount and a second condition regarding whether a charging rest time exceeds a threshold time.

According to some embodiments, the learning for the regression coefficients is performed based on a lightweight gradient boosting machine (light GBM) or linear regression.

According to some embodiments, a battery management method includes acquiring battery data of a battery, calculating a first state of health (SOH) value of the battery based on the battery data, calculating a first SOH correction value for the first SOH value using a regression equation that calculates an SOH correction value based on error factors causing an error in the first SOH value, and calculating a second SOH value by applying the first SOH correction value to the first SOH value.

According to some embodiments, the battery data includes charge data that is cumulatively collected each time a charging of the battery satisfies a validity condition, and the second SOH value is calculated based on the charge data.

According to some embodiments, the charge data includes charge open circuit voltage (OCV) data and charge current data of each of valid chargings satisfying the validity condition within a period of interest, and the calculating of the first SOH value includes calculating the first SOH value for each of the valid chargings based on SOC data and the charge current data corresponding to the charge OCV data.

According to some embodiments, the regression coefficients of the regression equation for the error factors are learned to calculate the first SOH correction value based on first SOH values for the valid chargings.

According to some embodiments, a first SOH deviation value of each of the first SOH values with respect to a representative value of the first SOH values is set as a residual of the regression equation, and the regression coefficients are learned to minimize the residuals of the regression equation.

According to some embodiments, the error factors include at least one of a charging start SOC according to the SOC data, a charging end SOC according to the SOC data, a charging start temperature, and a charging end temperature.

According to some embodiments, the regression equation is constructed based on a multivariate polynomial including terms composed of combinations of the error factors.

According to some embodiments, the calculating of the first SOH correction value includes calculating the first SOH correction values for the valid chargings by applying the error factors for each of the valid chargings to the regression coefficients of the regression equation after completion of learning.

According to some embodiments, the validity condition includes a first condition regarding whether a charge amount exceeds a threshold amount and a second condition regarding whether a charging rest time exceeds a threshold time.

According to some embodiments, the learning for the regression coefficients is performed based on a lightweight gradient boosting machine (light GBM) or linear regression.

**ADVANTAGEOUS EFFECTS**

According to the embodiments disclosed herein, it is possible to provide a battery management device and a battery management method capable of estimating a more accurate SOH value by correcting an error that occurs when calculating an SOH value using a charge current and charging SOC values.

The technical effects according to the embodiments disclosed herein are not limited to those mentioned above, and other effects not mentioned will be clearly understood by those skilled in the art from the disclosure herein.

**BRIEF DESCRIPTION OF THE DRAWINGS**

FIG. 1 illustrates elements constituting a battery management system according to some embodiments.
FIG. 2 illustrates elements constituting a battery management device according to some embodiments.
FIG. 3 illustrates a process of calculating an SOH value using charge current and charging SOC values according to some embodiments.

FIG. 4 illustrates a method of cumulatively collecting charge data each time a charging of a battery satisfies a validity condition according to some embodiments.

FIG. 5 illustrates charge data that is cumulatively collected each time a charging of a battery satisfies a validity condition according to some embodiments.

FIG. 6 illustrates SOH values calculated based on charge data according to some embodiments.

FIG. 7 illustrates a machine learning model utilized to correct charge data-based SOH values according to some embodiments.

FIG. 8 illustrates a method for setting a regression equation to be learned by a machine learning model to correct charge data-based SOH values according to some embodiments.

FIG. 9 illustrates a process of calculating a first SOH correction value and a second SOH value using a regression equation according to some embodiments.

FIG. 10 illustrates a difference between variation of an SOH according to an error factor before correction and variation of an SOH according to an error factor after correction according to some embodiments.

FIG. 11 illustrates a difference between SOH distribution before correction and SOH distribution after correction according to some embodiments.

FIG. 12 illustrates steps constituting a battery management method according to some embodiments.

## MODE FOR CARRYING OUT THE INVENTION

Hereinafter, embodiments disclosed in herein will be described with reference to the accompanying drawings. However, this is not intended to limit the disclosure herein to the specific embodiments, and it is to be construed to include various modifications, equivalents, and/or alternatives of embodiments disclosed herein.

It should be appreciated that embodiments herein and the terms used therein are not intended to limit the technological features set forth herein to particular embodiments and include various changes, equivalents, or replacements for a corresponding embodiment. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st," "2nd," "first," "second," "A," "B," "(a)," or "(b)" may be used to simply distinguish a corresponding component from another, and do not limit the components in other aspects (e.g., importance or order) unless specifically stated otherwise.

In the present specification, it is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., a compact disc read only memory and CD-ROM), or be distributed (e.g., downloaded or uploaded) online via an application store, or between two operator devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the plurality of entities may be disposed separately from other components. According to embodiments disclosed herein, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

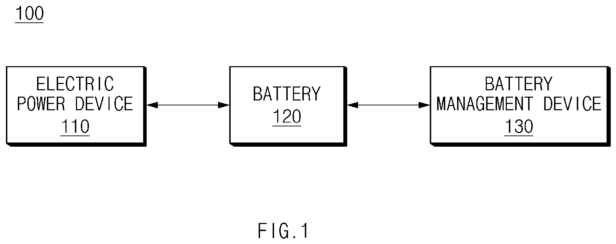

FIG. 1 may illustrate elements constituting a battery management system according to some embodiments.

Referring to FIG. 1, a battery management system 100 may include a power usage device 110, a battery 120, and a battery management device 130. However, the battery management system is not limited thereto, and some components may be omitted from the battery management system 100, or other general-purpose components may be further included in the battery management system 100.

The power usage device 110 may be configured to charge or discharge the battery 120. The power usage device 110 may discharge the battery 120 while consuming electric power, and may charge the battery 120 while generating electric power. According to an embodiment, the power usage device 110 may include a mobility device such as an electric vehicle (EV), a hybrid electric vehicle (HEV), an electric bike, or the like. The mobility device may drive a motor based on electric power from the battery 120 or charge the battery 120 with electric power generated through regenerative braking. In an embodiment, the power usage device 110 may include a charge/discharge device that provides charge and discharge cycles to the battery 120.

The battery 120 may include a battery pack or the like that is a diagnostic target of the system 100. The battery pack of the battery 120 may include a plurality of battery modules, and each battery module may include a plurality of battery cells. According to an embodiment, the battery 120 may be mounted on various types of mobility devices.

The battery management device 130 may perform operations for diagnosing or managing the battery 120. The battery management device 130 may acquire battery data of the battery 120 and diagnose or manage a state of the battery 120 to be diagnosed based on the battery data. According to an embodiment, the battery management device 130 may include a battery management system (BMS) configured with the battery 120 in an on-board manner, and/or an external device disposed remotely with the battery 120 in an off-board manner. The external device may include a charger of battery charging stations, a battery diagnostic device, a cloud computing server, or the like.

The battery management system 100 may further include a management server. The management server may manage management results of the battery management device 130. The management server may exchange data with the battery management device 130 via wired/wireless communication. When a defect in the battery 120 is diagnosed or its lifespan is predicted, the results may be transmitted to the management server and recorded in a database. According to an embodiment, the battery management device 130 may perform diagnostic operations by executing battery management software, and the management server may provide update information about the battery management software to the battery diagnostic device 130.

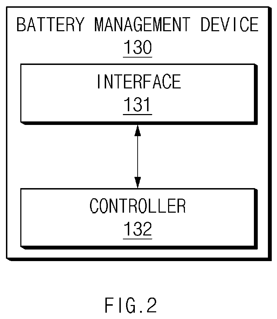

FIG. 2 may illustrate elements constituting a battery management device according to some embodiments.

Referring to FIG. 2, the battery management device 130 may include an interface 131 and a controller 132. However, the battery management device is not limited thereto, and some components may be omitted from the battery management device 130, or other general-purpose components may be further included in the battery management device 130.

The interface 131 may acquire battery data of the battery 120. According to an embodiment, the interface 131 may include a communication unit configured to receive battery data and/or a sensor unit configured to measure battery data. According to an embodiment, when the battery management device 130 is implemented in an off-board form, the communication unit may receive battery data in a manner such as wired data communication, wireless data communication, or the like. Alternatively, when the battery management device 130 is implemented in the on-board form, the sensor unit may be configured to measure values such as voltage, current, temperature, and resistance associated with the battery 120.

The controller 132 may have a structure for executing commands that implement operations of the battery management device 130. The controller 132 may be implemented as an array of a number of logic gates for processing various operations or as a general-purpose microprocessor, and may consist of a single processor or a plurality of processors. For example, the controller 132 may be implemented in the form of at least one of a microprocessor, a central processing unit (CPU), a graphics processing unit (GPU), and an application processor (AP).

The controller 132 may operate together with a memory configured to store various data, commands, mobile applications, computer programs, and the like. The memory may be configured separately from or integrally with the controller 132. The controller 132 may process various operations by executing commands stored in the memory. The memory may be implemented in a form of a non-volatile device such as a read-only memory (ROM), a programmable ROM (PROM), an erasable programmable ROM (EPROM), an electrically erasable PROM (EEPROM), a flash memory, a parallel random-access memory (PRAM), a magneto-resistive RAM (MRAM), a resistive RAM (RRAM), a ferroelectric RAM (FRAM), or the like, or a volatile device such as a dynamic RAM (DRAM), a static RAM (SRAM), a synchronous dynamic RAM (SDRAM), a parallel RAM (PRAM), or the like, or may be implemented in a form of a hard disk drive (HDD), a solid state drive (SSD), a secure digital (SD), Micro-SD, or a combined form thereof.

The interface 131 may be configured to acquire battery data of the battery 120. According to an embodiment, the interface 131 may include a communication unit configured to receive battery data and/or a sensor unit configured to measure battery data. According to an embodiment, when the battery management device 130 is implemented in an off-board form, the communication unit may receive battery data in a manner such as wired data communication, wireless data communication, or the like. Alternatively, when the battery management device 130 is implemented in the on-board form, the sensor unit may be configured to measure values such as voltage, current, temperature, and resistance associated with the battery 120. According to an embodiment, the battery data may include charge data related to charging of the battery 120 and/or discharge data related to discharging.

The controller 132 may be configured to calculate a first SOH value of the battery 120 based on the battery data.

According to an embodiment, the battery data may include data regarding charging and/or discharging of the battery 120, and the first SOH value may be an SOH value calculated using the charge current and charging SOC values. The first SOH value may be raw data before correcting errors in an SOH value caused by error factors.

The controller 132 may be configured to calculate a first SOH correction value for the first SOH value using a regression equation that calculates an SOH correction value based on error factors that cause an error in the first SOH value. According to an embodiment, the regression equation may have error factors as independent variables or input variables, and the first SOH correction value as a dependent variable or output variable. The regression equation may be constructed in the form of a multivariate polynomial, and a regression coefficient for each term of the multivariate polynomial may be learned using various machine learning techniques. According to an embodiment, error factors may include variables such as voltage, current, temperature, and resistance related to charging and/or discharging of the battery 120. According to an embodiment, the first SOH correction value may be set as a deviation value from the mean or median of the first SOH value for a certain period of time, and may be adjusted to a specific value according to training for the regression equation.

The controller 132 may be configured to calculate a second SOH value by applying the first SOH correction value to the first SOH value. According to an embodiment, the second SOH value may be calculated by subtracting the first SOH correction value from the first SOH value. The second SOH value may be a result of correcting errors due to error factors present in the first SOH value.

According to an embodiment, the battery data may include charge data that is cumulatively collected each time the charging of the battery 120 satisfies a validity condition, and the controller 132 may be configured to calculate the second SOH value based on the charge data. The validity condition is intended to ensure data validity and may include a condition regarding the amount of charge and/or discharge of the battery 120, a condition regarding a time point of data collection, or the like. For example, data satisfying the validity condition among data on charging, discharging, SOC fluctuations, and the like of the battery 120 for three months, six months, one year, or other periods of time may be collected as the charge data. Calculation of the first SOH value and training for the regression equation may be performed based on the charge data.

According to an embodiment, the charge data may include charge open circuit voltage (OCV) data and charge current data of each of valid chargings satisfying the validity condition within a period of interest, and the controller 132 may be configured to calculate the first SOH value for each of the valid chargings based on SOC data and the charge current data corresponding to the charge OCV data. The valid chargings may include charges that satisfy a condition regarding the amount of charge, a condition regarding a time point of collection of OCV data, or the like, among charges of the battery 120 within the period of interest. The SOC data corresponding to the charge OCV data may be derived based on a pre-prepared OCV-SOC mapping profile or the like. According to an embodiment, the first SOH value may be calculated based on a charging start SOC, a charging end SOC, and a charge current of each valid charging.

According to an embodiment, the regression coefficients of the regression equation for the error factors may be learned to calculate the first SOH correction value based on the first SOH values for the valid chargings. The regression equation may have the error factors as independent/input variables and the first SOH correction value as a dependent/output variable. Terms in the regression equation may be set based on the error factors, and the regression coefficients for the terms in the regression equation may be adjusted through training for the regression equation. The first SOH correction value may be calculated based on the learned regression coefficients.

According to an embodiment, a first SOH deviation value of each of the first SOH values with respect to a representative value of the first SOH values may be set as a residual of the regression equation, and the regression coefficients may be learned to minimize the residuals of the regression equation. For example, when there are n valid chargings within the period of interest, there may be n first SOH values corresponding to the valid chargings, respectively. The mean, median, mode, or the like of the n first SOH values may be set as a representative value, and the first SOH deviation value may be a difference between each first SOH value and the representative value. According to an embodiment, before the training for the regression equation, the first SOH deviation value may be set as an output and dependent variable of the regression equation, and when the training for the regression equation is completed, the first SOH deviation value may function as the first SOH correction value. For example, the regression equation may be set to output the first SOH deviation value by applying regression coefficients to terms formed through combinations of error factors, where the first SOH deviation value may function as the residual of the regression equation. The regression coefficients may be learned to minimize a residual sum of squares (RSS) of the n first SOH deviation values, or other regression learning techniques other than the residual sum of squares (RSS) may be utilized.

According to an embodiment, the error factors may include at least one of a charging start SOC according to the SOC data, a charging end SOC according to the SOC data, a charging start temperature, and a charging end temperature. For example, although the charging start temperature is not used while calculating the first SOH value, the first SOH value may vary depending on the charging start temperature when other conditions are the same. Therefore, the charging start temperature may correspond to an error factor of the first SOH value, and the remaining charging start SOC, charging end SOC, and charging end temperature may also correspond to error factors in a similar manner.

According to an embodiment, the regression equation may be constructed based on a multivariate polynomial that includes terms composed of combinations of error factors. For example, when the error factors are the charging start SOC (x1) and the charging end SOC (x2), and the degree of the multivariate polynomial is 3, the possible combinations of the error factors may be $x1^3$, $x2^3$, $x1^2*x2$, $x1*x2^2$, $x1^2$, $x1*x2$, $x2^2$, $x1$, $x2$, a constant term, and the like. These 10 terms may construct the multivariate polynomial regression equation, and 10 regression coefficients for that may be learned. Unlike this example, the number of error factors and the degree of the multivariate polynomial may be set differently. Since various combinations of the error factors are utilized in the form of the multivariate polynomial, the error factors interact with each other and influence each other, so that factors that cause errors in the first SOH value may be reflected in an SOH correction process.

According to an embodiment, the controller 132 may be configured to calculate the first SOH correction values for the valid chargings by applying error factors for each of the valid chargings to the regression coefficients of the regression equation after completion of learning. For example, when the regression equation, which is a third-order polynomial with respect to two variables, includes 10 terms, such as $x1^3$, $x2^3$, $x1^2*x2$, $x1*x2^2$, $x1^2$, $x1*x2$, $x2^2$, $x1$, $x2$, and a constant term, the 10 regression coefficients may be adjusted through training, and when the training to obtain the 10 regression coefficients is completed, the first SOH deviation value corresponding to the difference between the first SOH value and the representative value may be calculated by substituting x1 and x2 into the third-order polynomial with respect to two variables. The first SOH deviation value calculated by the regression equation after completion of learning may be the first SOH correction value.

According to an embodiment, the validity condition may include a first condition regarding whether the charge amount exceeds a threshold amount and a second condition regarding whether a charging rest time exceeds a threshold time. For example, the first condition may be a condition where the charge amount is greater than or equal to dod 25%. Dod 25% or greater may mean that the difference between the charging end SOC and the charging start SOC is greater than or equal to 25%. The second condition may be that the charging rest time is two hours or more. The charging rest time may refer to a duration between when charging is completed and before measuring a voltage. When the rest time is not sufficient, it may be difficult to consider the measured voltage as the OCV. When a sufficient rest time is provided, the measured voltage may be considered as the OCV. Exemplary figures such as 25% or more of the first condition and two hours or more of the second condition may be changed to different figures.

According to an embodiment, the training for the regression coefficients may be performed based on a lightweight gradient boosting machine (light GBM) or linear regression. The regression coefficients for terms of the multivariate polynomial generated by combinations of the error factors may be learned based on a lightweight gradient boosting machine (light GBM) or linear regression. The regression coefficients may be learned to minimize the residual sum of squares (RSS) or similar metrics.

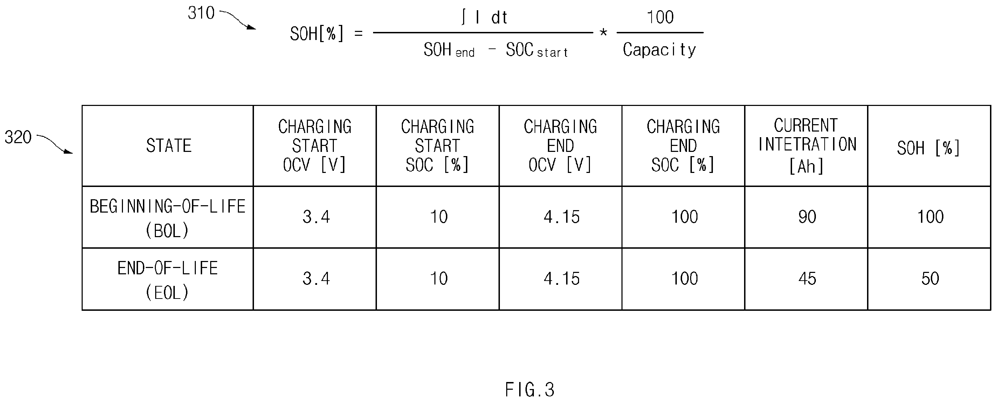

FIG. 3 illustrates a process of calculating an SOH value using charge current and charging SOC values according to some embodiments.

Referring to FIG. 3, equation 310 exemplifying the process of calculating an SOH value using charge current and charging SOC values and a table 320 for describing variables calculated in equation 310 may be illustrated.

In equation 310, a first SOH value may be calculated based on a charging start SOC ($SOC_{start}$), a charging end SOC ($SOC_{end}$), a charge current (I), and a capacity of the battery 120. The first SOH value may be calculated based on equation 310 for a valid charging satisfying a validity condition. The charge current (I) may be integrated while the valid charging is in progress.

The table 320 may illustrate an example of calculating the first SOH value based on equation 310 in different states. The charging start OCV, charging start SOC, charging end OCV, and charging end SOC at a beginning-of-life (BOL) state and an end-of-life (EOL) state may be the same, but the integrated value of the charge current (I) may become different due to battery aging, which may lead to a difference in the first SOH value.

Equation 310 does not consider temperature factors, but the charging temperature may be a factor that causes an error in the first SOH value. In addition, equation 310 only considers the difference between the charging start SOC and the charging end SOC, but when the charging start SOC or the charging end SOC becomes different for the same difference value, the first SOH value may change. Therefore, the charging start SOC or charging end SOC may also be error factors. In addition to these, when calculating the first SOH value based on equation 310, various factors that cause errors in the first SOH value may be utilized as error factors of the regression equation.

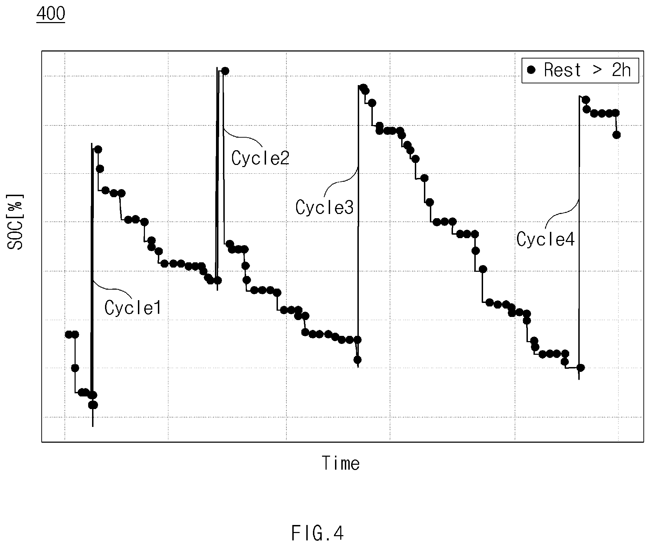

FIG. 4 illustrates a method of cumulatively collecting charge data each time a charging of a battery satisfies a validity condition according to some embodiments.

Referring to FIG. 4, a graph 400 may be illustrated exemplifying the method of cumulatively collecting charge data each time charging of the battery 120 satisfies a validity condition. A horizontal axis of the graph 400 may represent time.

A voltage measured after a rest time of two hours or more has elapsed in the graph 400 may be treated as an OCV value, and the OCV value may be converted into an SOC value through a mapping table or the like. The SOC value converted from the OCV value may be recorded as one point on the graph 400. According to an embodiment, measurement of the OCV value and conversion of the SOC value may be performed each time use of the power usage device 110 is terminated or each time charge of the power usage device 110 is completed. When the power usage device 110 is a mobility device, as illustrated in the graph 400, the SOC may gradually decrease as the mobility device travels and then significantly increase due to chargings of the mobility device.

When the SOC difference between adjacent SOC values exceeds, for example, 25%, or another appropriate value, the SOC difference may be recorded as one cycle. A plurality of cycles recorded during three months, six months, one year, or any other period of interest may form a charge data set. A first SOH value may be calculated for each of a plurality of cycles of charge data. For example, when there are n cycles during the period of interest, n first SOH values may be calculated, and through an SOH correction process, one or more but not more than n second SOH values may be calculated.

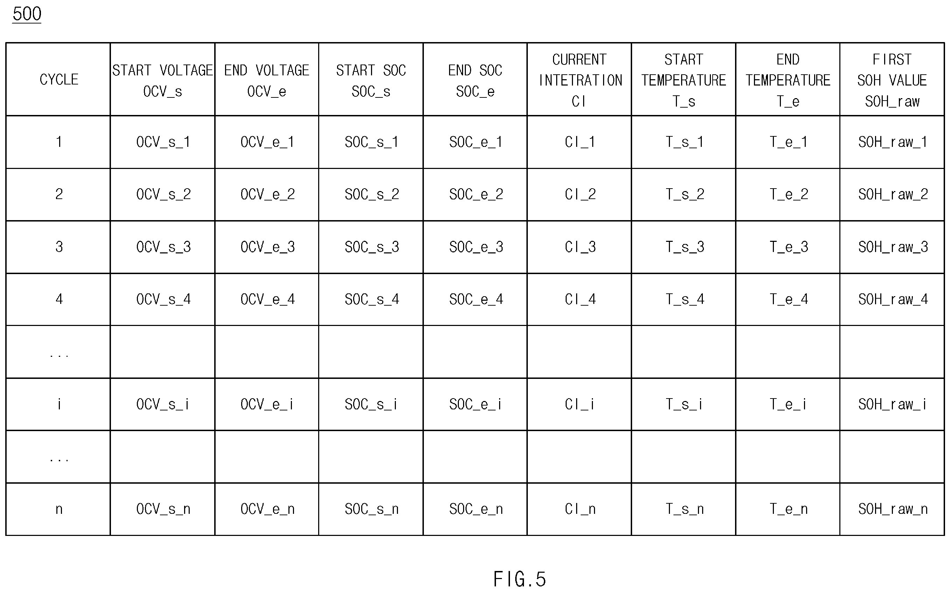

FIG. 5 illustrates charge data that is cumulatively collected each time a charging of a battery satisfies a validity condition according to some embodiments.

Referring to FIG. 5, a table 500 may be illustrated exemplifying charge data that is cumulatively collected each time the charging of the battery 120 satisfies a validity condition. The table 500 may represent n cycles collected during a period of interest.

A start SOC SOC_s and an end SOC SOC_e may be calculated based on a start voltage OCV_s and an end voltage OCV_e recorded in a cycle of each row of the table 500, and a current integration CI based on the charge current for the cycle of each row may be calculated. In the cycle of each row, a first SOH value SOH_raw may be calculated based on the start SOC SOC_s, the end SOC SOC_e and the current integration CI. When n cycles are collected during the period of interest, n first SOH values SOH_raw for them may be calculated.

The charge data of the table 500 may include a start temperature T_s and an end temperature T_e of each charging cycle. The start temperature T_s and the end temperature T_e may not be reflected in the calculation process of the first SOH value SOH_raw. However, the start temperature T_s and the end temperature T_e may be error factors that affect a calculation result of the first SOH value SOH_raw. The errors due to the start temperature T_s and the end temperature T_e may be reflected in the training process for the regression equation, and the learned regression equation may output the first SOH correction value to correct the errors due to the start temperature T_s and the end temperature T_e.

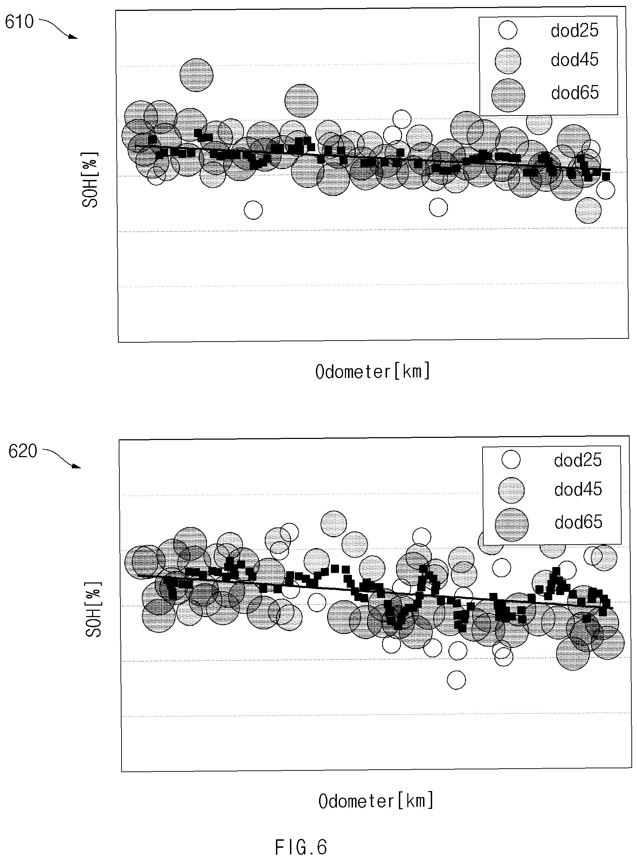

FIG. 6 illustrates SOH values calculated based on charge data according to some embodiments.

Referring to FIG. 6, a first graph 610 and a second graph 620 illustrating SOH values calculated based on charge data may be illustrated. Horizontal axes of the first graph 610 and the second graph 620 may represent traveling distances of a battery-equipped vehicle, and the vertical axes may represent the battery SOHs.

The first graph 610 and the second graph 620 may be graphs for different first and second vehicles. In both the first graph 610 and the second graph 620, it may be confirmed that the SOH tends to decrease as a traveling distance increases. The SOH of vertical axes of the first graph 610 and the second graph 620 may correspond to the first SOH value in a state where SOH correction by the battery management device 130 is not performed. A high dispersion in SOH values may be seen in both the first graph 610 and the second graph 620. The dispersion of SOH values may be higher when a value of a depth of discharge (dod) is lower. For example, dod25 may represent SOH values calculated for data where the SOC difference due to charging is greater than or equal to 25%, and dod45 and dod65 may also represent similar meanings.

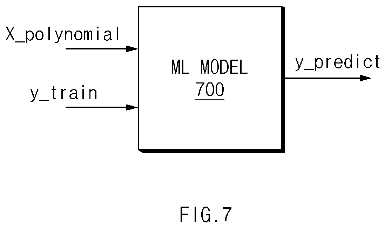

FIG. 7 illustrates a machine learning model utilized to correct charge data-based SOH values according to some embodiments.

Referring to FIG. 7, an ML model 700 may be trained to obtain regression coefficients in a regression equation X_polynomial based on training data y_train and output prediction data y_predict using the regression equation X_polynomial after completion of learning.

The regression equation X_polynomial may take the form of a multivariate polynomial. Terms of the multivariate polynomial may be set based on combinations of error factors that cause an error in the first SOH value. For example, when the error factors are the charging start SOC x1 and the charging end SOC x2, and the degree of the multivariate polynomial is 2, the possible combinations of the error factors may be $x1^2$, $x2^2$, $x1*x2$, x1, x2, a constant term, and the like. In this case, six regression coefficients $\beta_1$ to $\beta_6$ for six terms may form the multivariate polynomial, and the dependent/output variable of the regression equation X_polynomial may be training data y_train or prediction data y_predict.

[Equation 1]

$$\beta_1*x1^2 + \beta_2*x2^2 + \beta_3*x1*x2 + \beta_4*x1 + \beta_5*x2 + \beta_6*c = y$$

Equation 1 may represent the form of an exemplary regression equation. Before training for the regression coefficients is completed, y may be the training data y_train, and after training for the regression coefficients is completed, y may be the prediction data y_predict. According to an embodiment, the training data y_train or the prediction data y_predict may be a first SOH deviation value corresponding to a difference between a representative value of n first SOH values and each first SOH value, and the first SOH deviation value may function as a residual of the regression equation. For example, the regression coefficients may be learned to minimize the residual sum of squares (RSS), and a lightweight gradient boosting machine (light GBM), linear regression, or any other appropriate technique may be used for training to obtain such coefficients of the regression equation. Once the adjustment of the regression coefficients $\beta1$ to $\beta6$ has been completed through training, when the input variables (x1, x2) are entered into the regression equation, the prediction data y_predict may be output, and in this case, the prediction data y_predict may be the first SOH correction values.

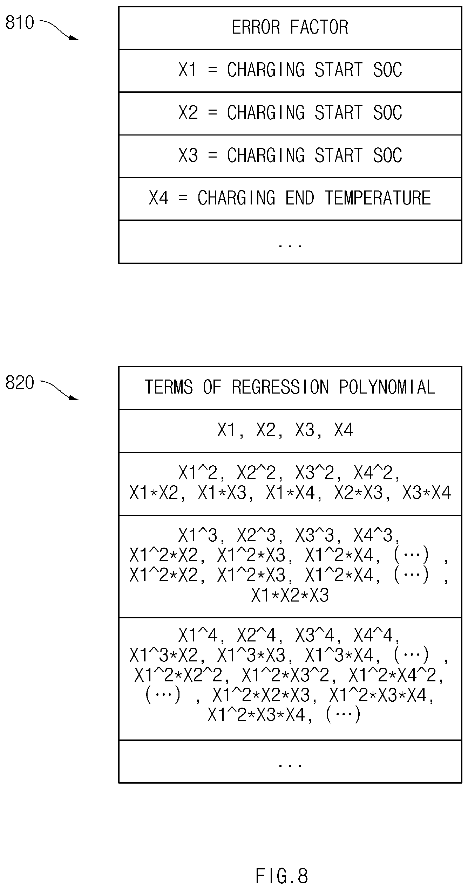

FIG. 8 illustrates a method for setting a regression equation to be learned by a machine learning model to correct charge data-based SOH values according to some embodiments.

Referring to FIG. 8, a first table 810 and a second table 820 may be illustrated exemplifying a method for setting a regression equation to be learned by a machine learning model to correct charge data-based SOH values.

The first table 810 may indicate the types of error factors that cause errors in the first SOH values. For example, error factors of the first table 810 may include a charging start SOC, a charging end SOC, a charging start temperature, a charging end temperature, and the like. Terms of the regression equation may be set based on combinations of error factors of the first table 810. The second table 820 may represent an example of setting the terms of the regression equation based on combinations of four error factors x1 to x4. In the second table 820, the terms of the regression equation may include first-order terms, second-order terms, third-order terms, fourth-order terms, and the like. When the number of error factors is 4, the regression equation may be a polynomial of fourth order or higher. The number of error factors in the first table 810 and the terms in the second table 820 are all exemplary, and regression equations of different forms may be utilized for SOH correction.

As in the second table 820, the terms of the regression equation may include terms generated by combining two or more error factors, such as x1*x2, x3*x4, or the like, and this may be a difference from the one-variable polynomial regression or multivariable linear regression that the regression equation has. Therefore, through training for the regression equation, the error caused by the interaction of two or more error factors in the first SOH values may be considered in combination. Accordingly, when an SOH correction procedure using a single-variable polynomial regression equation is repeated four times for each of the four error factors, the error caused by two or more error factors operating together is not considered, whereas a polynomial regression equation based on combinations of the four error factors may consider the error, thereby performing more accurate SOH correction.

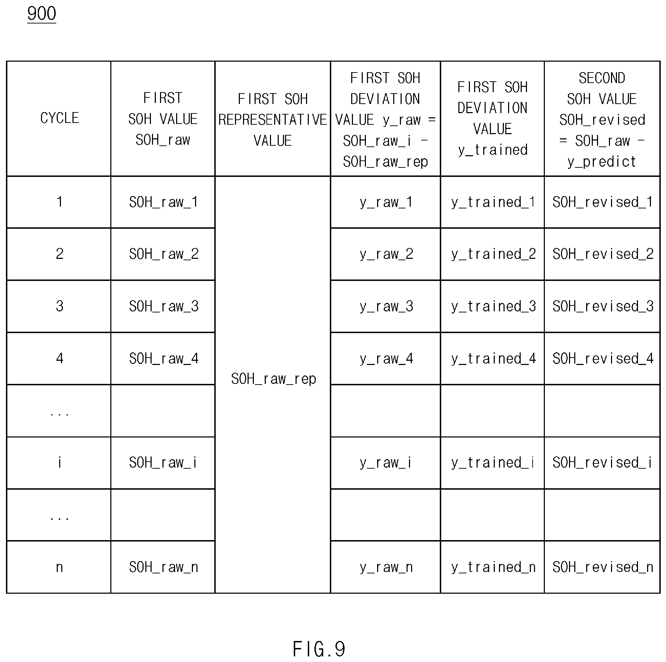

FIG. 9 illustrates a process of calculating a first SOH correction value and a second SOH value using a regression equation according to some embodiments.

Referring to FIG. 9, a table 900 exemplifying the process of calculating a first SOH correction value and a second SOH value using a regression equation may be illustrated. The table 900 may represent n valid chargings.

A first SOH representative value SOH_raw_rep for n first SOH values SOH_raw_1 to SOH_raw_n may be calculated. The first SOH representative value SOH_raw_rep may be a mean, median, mode, or the like. n first SOH deviation values y_raw_1 to y_raw_n may be calculated based on a difference with the first SOH representative value SOH_raw_rep. According to an embodiment, the n first SOH deviation values y_raw_1 to y_raw_n may function as residuals of the regression equation.

Training for the regression equation may be performed to minimize n residual sums of squares (RSS) or similar indices for n residuals, and the regression coefficients of the regression equation may be updated through such training. After training is completed, error factors may be input into the regression equation to output the y_trained value, and in this case, the y_trained value may correspond to the first SOH deviation value. When the first SOH deviation value is applied to each first SOH value, the second SOH value after the SOH correction has been completed may be calculated.

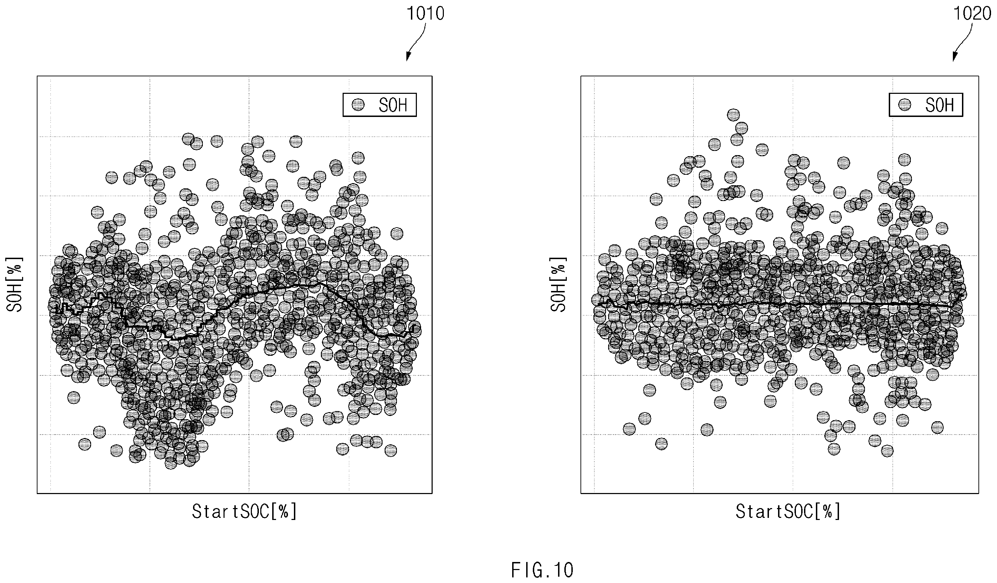

FIG. 10 illustrates a difference between variation of an SOH according to an error factor before correction and variation of an SOH according to an error factor after correction according to some embodiments.

Referring to FIG. 10, a first graph 1010 and a second graph 1020 may be illustrated exemplifying the difference between the variation of the SOH according to the error factor before correction and the variation of the SOH according to the error factor after correction.

A horizontal axis of the first graph 1010 may represent the charging start SOC, and a vertical axis may represent the first SOH value before correction. A horizontal axis of the second graph 1020 may represent the charging start SOC, and a vertical axis may represent the second SOH value after correction. As in the first graph 1010, when the value of the charging start SOC varies, the first SOH value also varies, so that the charging start SOC may cause an error in the first SOH value. On the other hand, as in the second graph 1020, since the second SOH value hardly varies and is constant even when the value of the charging start SOC changes, most of the errors due to the charging start SOC may be eliminated in the second SOH value.

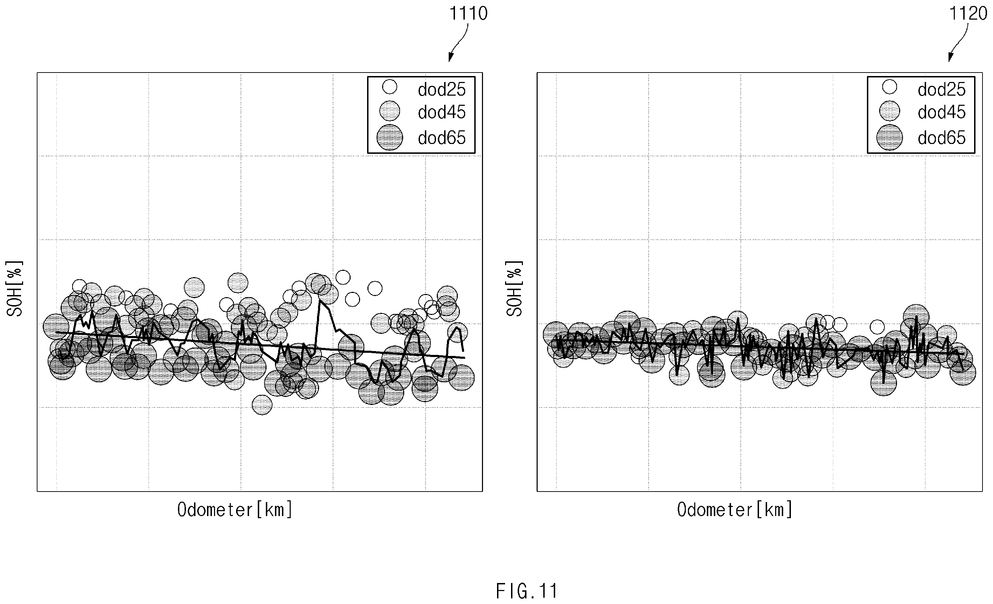

FIG. 11 illustrates a difference between SOH distribution before correction and SOH distribution after correction according to some embodiments.

Referring to FIG. 11, a first graph 1110 and a second graph 1120 may be illustrated exemplifying the difference between the SOH distribution before correction and the SOH distribution after correction.

A horizontal axis of the first graph 1110 may represent a traveling distance of a battery-equipped vehicle, and a vertical axis may represent the first SOH value before correction. A horizontal axis of the second graph 1120 may represent a traveling distance of a battery-equipped vehicle, and a vertical axis may represent the second SOH value after correction. As illustrated, a tendency for SOH to decrease as the traveling distance increases may be shown in the second graph 1120. In addition, in all cases of dod25, dod45, and dod65, it may be confirmed that the SOH dispersion of the second graph 1120 is lower than the SOH dispersion of the first graph 1120, which may mean that the SOH error factor has been resolved, enabling more accurate SOH estimation.

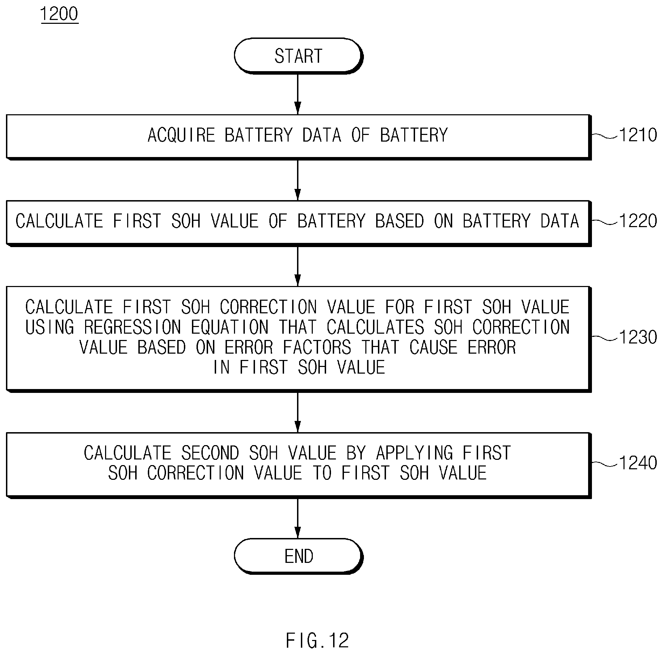

FIG. 12 illustrates steps constituting a battery management method according to some embodiments.

Referring to FIG. 12, a battery management method 1000 may include steps 1210 to 1240. However, the battery management method is not limited thereto, and some steps may be omitted or other general steps may be added, and the steps of the battery management method 1200 may be executed in a different order than the illustrated order.

The battery management method 1200 may include steps that are processed in time series in the battery management device 130. Therefore, even when the content is omitted below, the content described above for the battery management device 130 may be equally applied to the battery management method 1200.

Steps 1210 to 1240 of the battery management method 1200 may be performed by the interface 131 and controller 132 of the battery management device 130.

In step 1210, the battery management device 130 may perform a step of acquiring battery data of a battery.

In step 1220, the battery management device 130 may perform a step of calculating a first SOH value of the battery based on the battery data.

In step 1230, the battery management device 130 may perform a step of calculating a first SOH correction value for the first SOH value using a regression equation that calculates an SOH correction value based on error factors that cause an error in the first SOH value.

In step 1240, the battery management device 130 may perform a step of calculating a second SOH value by applying the first SOH correction value to the first SOH value.

According to an embodiment, the battery management method 1200 may be implemented in the form of a computer program stored in a computer-readable storage medium. That is, the computer program may include commands for implementing the battery management method 1200, and the commands of the program may be stored in the computer-readable storage medium. The computer program may include a mobile application.

In an embodiment, a computer-readable storage medium may include magnetic media such as hard disks, floppy disks, and magnetic tapes, optical media such as CD-ROMs and DVDs, magneto-optical media such as floptical disks, and a hardware device specially configured to store and execute computer program instructions, such as ROM, RAM, flash memory, or the like. Computer program instructions may include machine language code generated by a compiler and high-level language code that may be executed by a computer using an interpreter, or the like.

Terms such as "include," "comprise," or "have" described above mean that the corresponding component may be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The above description is merely an example of the technical idea disclosed herein, and those with ordinary skill in the art to which the embodiments disclosed herein belong may make various modifications and variations without departing from the essential characteristics of the embodiments disclosed herein. Accordingly, the embodiments disclosed herein are not intended to limit the technical ideas of the embodiments disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

(Reference Signs List)

| 100: | Battery management system | 110: | Power usage device |
|------|---------------------------|------|---------------------|
| 120: | Battery | 130: | Battery management system |
| 131: | Interface | 132: | Controller |

**Claims**

1. A battery management device comprising:

an interface configured to acquire battery data of a battery; and
a controller configured to:

calculate a first state of health (SOH) value of the battery based on the battery data;
calculate a first SOH correction value for the first SOH value using a regression equation that calculates an SOH correction value based on error factors causing an error in the first SOH value; and
calculate a second SOH value by applying the first SOH correction value to the first SOH value.

2. The battery management device of claim 1, wherein the battery data includes charge data that is cumulatively collected each time a charging of the battery satisfies a validity condition, and
the controller is configured to calculate the second SOH value based on the charge data.

3. The battery management device of claim 2, wherein the charge data includes charge open circuit voltage (OCV) data and charge current data of each of valid chargings satisfying the validity condition within a period of interest, and
the controller is configured to calculate the first SOH value for each of the valid chargings based on SOC data and the charge current data corresponding to the charge OCV data.

4. The battery management device of claim 3, wherein regression coefficients in the regression equation for the error factors are learned to calculate the first SOH correction value based on first SOH values for the valid charging.

5. The battery management device of claim 4, wherein a first SOH deviation value of each of the first SOH values with respect to a representative value of the first SOH values is set as a residual of the regression equation, and
the regression coefficients are learned to minimize the residuals of the regression equation.

6. The battery management device of claim 5, wherein the error factors include at least one of a charging start SOC according to the SOC data, a charging end SOC according to the SOC data, a charging start temperature, and a charging end temperature.

7. The battery management device of claim 6, wherein the regression equation is constructed based on a multivariate polynomial including terms composed of combinations of the error factors.

8. The battery management device of claim 7, wherein the controller is configured to calculate the first SOH correction values for the valid chargings by applying the error factors for each of the valid chargings to the regression coefficients of the regression equation after completion of learning.

9. The battery management device of claim 2, wherein the validity condition includes a first condition regarding whether a charge amount exceeds a threshold amount and a second condition regarding whether a charging rest time exceeds a threshold time.

10. The battery management device of claim 5, wherein the training for the regression coefficients is performed based on a lightweight gradient boosting machine (light GBM) or linear regression.

11. A battery management method, comprising:

acquiring battery data of a battery;
calculating a first state of health (SOH) value of the battery based on the battery data;
calculating a first SOH correction value for the first SOH value using a regression equation that calculates an SOH correction value based on error factors causing an error in the first SOH value; and
calculating a second SOH value by applying the first SOH correction value to the first SOH value.

12. The battery management method of claim 11, wherein the battery data includes charge data that is cumulatively collected each time a charging of the battery satisfies a validity condition, and the second SOH value is calculated based on the charge data.

13. The battery management method of claim 12, wherein the charge data includes charge open circuit voltage (OCV) data and charge current data of each of valid chargings satisfying the validity condition within a period of interest, and the calculating of the first SOH value includes calculating the first SOH value for each of the valid chargings based on SOC data and the charge current data corresponding to the charge OCV data.

14. The battery management method of claim 13, wherein regression coefficients in the regression equation for the error factors are learned to calculate the first SOH correction value based on first SOH values for the valid chargings.

15. The battery management method of claim 14, wherein a first SOH deviation value of each of the first SOH values with respect to a representative value of the first SOH values is set as a residual of the regression equation, and the regression coefficients are learned to minimize the residuals of the regression equation.

16. The battery management method of claim 15, wherein the error factors include at least one of a charging start SOC according to the SOC data, a charging end SOC according to the SOC data, a charging start temperature, and a charging end temperature.

17. The battery management method of claim 16, wherein the regression equation is constructed based on a multivariate polynomial including terms composed of combinations of the error factors.

18. The battery management method of claim 17, wherein the calculating of the first SOH correction value includes calculating the first SOH correction values for the valid chargings by applying the error factors for each of the valid chargings to the regression coefficients of the regression equation after completion of learning.

19. The battery management method of claim 12, wherein the validity condition includes a first condition regarding whether a charge amount exceeds a threshold amount and a second condition regarding whether a charging rest time exceeds a threshold time.

20. The battery management method of claim 15, wherein the learning for the regression coefficients is performed based on a lightweight gradient boosting machine (light GBM) or linear regression.

100

| ELECTRIC POWER DEVICE 110 | ↔ | BATTERY 120 | ↔ | BATTERY MANAGEMENT DEVICE 130 |

FIG.1

```
┌─────────────────────────────────────┐
│   BATTERY  MANAGEMENT  DEVICE        │
│              130                     │
│  ┌───────────────────────────────┐  │
│  │         INTERFACE             │  │
│  │           131                 │  │
│  └───────────────────────────────┘  │
│                 ↕                    │
│  ┌───────────────────────────────┐  │
│  │        CONTROLLER             │  │
│  │           132                 │  │
│  └───────────────────────────────┘  │
└─────────────────────────────────────┘
```

FIG.2

310

$$SOH[\%] = \frac{\int I \, dt}{SOH_{end} - SOC_{start}} * \frac{100}{Capacity}$$

320

| STATE | CHARGING START OCV [V] | CHARGING START SOC [%] | CHARGING END OCV [V] | CHARGING END SOC [%] | CURRENT INTETRATION [Ah] | SOH [%] |
|---|---|---|---|---|---|---|
| BEGINNING-OF-LIFE (BOL) | 3.4 | 10 | 4.15 | 100 | 90 | 100 |
| END-OF-LIFE (EOL) | 3.4 | 10 | 4.15 | 100 | 45 | 50 |

FIG.3

400

FIG.4

500

| CYCLE | START VOLTAGE OCV_s | END VOLTAGE OCV_e | START SOC SOC_s | END SOC SOC_e | CURRENT INTETRATION CI | START TEMPERATURE T_s | END TEMPERATURE T_e | FIRST SOH VALUE SOH_raw |
|---|---|---|---|---|---|---|---|---|
| 1 | OCV_s_1 | OCV_e_1 | SOC_s_1 | SOC_e_1 | CI_1 | T_s_1 | T_e_1 | SOH_raw_1 |
| 2 | OCV_s_2 | OCV_e_2 | SOC_s_2 | SOC_e_2 | CI_2 | T_s_2 | T_e_2 | SOH_raw_2 |
| 3 | OCV_s_3 | OCV_e_3 | SOC_s_3 | SOC_e_3 | CI_3 | T_s_3 | T_e_3 | SOH_raw_3 |
| 4 | OCV_s_4 | OCV_e_4 | SOC_s_4 | SOC_e_4 | CI_4 | T_s_4 | T_e_4 | SOH_raw_4 |
| ... | | | | | | | | |
| i | OCV_s_i | OCV_e_i | SOC_s_i | SOC_e_i | CI_i | T_s_i | T_e_i | SOH_raw_i |
| ... | | | | | | | | |
| n | OCV_s_n | OCV_e_n | SOC_s_n | SOC_e_n | CI_n | T_s_n | T_e_n | SOH_raw_n |

FIG.5

FIG.6

X_polynomial →

y_train →

ML MODEL
700

→ y_predict

FIG.7

810 ⌇

| ERROR FACTOR |
| --- |
| X1 = CHARGING START SOC |
| X2 = CHARGING START SOC |
| X3 = CHARGING START SOC |
| X4 = CHARGING END TEMPERATURE |
| . . . |

820 ⌇

| TERMS OF REGRESSION POLYNOMIAL |
| --- |
| X1, X2, X3, X4 |
| X1^2, X2^2, X3^2, X4^2, X1*X2, X1*X3, X1*X4, X2*X3, X3*X4 |
| X1^3, X2^3, X3^3, X4^3, X1^2*X2, X1^2*X3, X1^2*X4, (···), X1^2*X2, X1^2*X3, X1^2*X4, (···), X1*X2*X3 |
| X1^4, X2^4, X3^4, X4^4, X1^3*X2, X1^3*X3, X1^3*X4, (···), X1^2*X2^2, X1^2*X3^2, X1^2*X4^2, (···), X1^2*X2*X3, X1^2*X3*X4, X1^2*X3*X4, (···) |
| . . . |

FIG.8

900

| CYCLE | FIRST SOH VALUE SOH_raw | FIRST SOH REPRESENTATIVE VALUE | FIRST SOH DEVIATION VALUE $y\_raw = SOH\_raw\_i - SOH\_raw\_rep$ | FIRST SOH DEVIATION VALUE $y\_trained$ | SECOND SOH VALUE $SOH\_revised = SOH\_raw - y\_predict$ |
|---|---|---|---|---|---|
| 1 | SOH_raw_1 | | y_raw_1 | y_trained_1 | SOH_revised_1 |
| 2 | SOH_raw_2 | | y_raw_2 | y_trained_2 | SOH_revised_2 |
| 3 | SOH_raw_3 | | y_raw_3 | y_trained_3 | SOH_revised_3 |
| 4 | SOH_raw_4 | | y_raw_4 | y_trained_4 | SOH_revised_4 |
| ... | | SOH_raw_rep | | | |
| i | SOH_raw_i | | y_raw_i | y_trained_i | SOH_revised_i |
| ... | | | | | |
| n | SOH_raw_n | | y_raw_n | y_trained_n | SOH_revised_n |

FIG.9

FIG.10

FIG.11

1200

```
        ┌─────────┐
        │  START  │
        └─────────┘
             │
             ▼
┌───────────────────────────────────────────────────┐
│        ACQUIRE BATTERY DATA OF BATTERY             │──1210
└───────────────────────────────────────────────────┘
             │
             ▼
┌───────────────────────────────────────────────────┐
│ CALCULATE FIRST SOH VALUE OF BATTERY BASED ON BATTERY DATA │──1220
└───────────────────────────────────────────────────┘
             │
             ▼
┌───────────────────────────────────────────────────┐
│  CALCULATE FIRST SOH CORRECTION VALUE FOR FIRST SOH VALUE │
│  USING REGRESSION EQUATION THAT CALCULATES SOH CORRECTION │──1230
│      VALUE BASED ON ERROR FACTORS THAT CAUSE ERROR        │
│                  IN FIRST SOH VALUE                       │
└───────────────────────────────────────────────────┘
             │
             ▼
┌───────────────────────────────────────────────────┐
│       CALCULATE SECOND SOH VALUE BY APPLYING FIRST │
│        SOH CORRECTION VALUE TO FIRST SOH VALUE     │──1240
└───────────────────────────────────────────────────┘
             │
             ▼
        ┌─────────┐
        │   END   │
        └─────────┘
```

FIG.12

## INTERNATIONAL SEARCH REPORT

| International application No. |
|---|
| **PCT/KR2025/002967** |

**A. CLASSIFICATION OF SUBJECT MATTER**

**G01R 31/374**(2019.01)i; **G01R 31/392**(2019.01)i; **G01R 31/36**(2006.01)i; **G01R 31/3842**(2019.01)i; **G01R 31/367**(2019.01)i; **G01R 31/396**(2019.01)i; **H01M 10/48**(2006.01)i; **G01R 31/382**(2019.01)i

According to International Patent Classification (IPC) or to both national classification and IPC

**B. FIELDS SEARCHED**

Minimum documentation searched (classification system followed by classification symbols)

G01R 31/374(2019.01); G01R 31/36(2006.01); G01R 31/367(2019.01); G01R 31/392(2019.01); G06N 3/08(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), SOH(state of health), OCV(open circuit voltage), 오차 인자(error factor), 보정(correction), 회귀 방정식(regression equation)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2023-0157549 A (KOREA AUTOMOTIVE TECHNOLOGY INSTITUTE) 17 November 2023 (2023-11-17) claims 1, 4, 7, 9; and figures 1-8. | 1-4,9,11-14,19 |
| A | | 5-8,10,15-18,20 |
| Y | KR 10-2015-0120697 A (SAMSUNG ELECTRONICS CO., LTD.) 28 October 2015 (2015-10-28) paragraphs [17], [80], [85]; and figures 1-14. | 1-4,9,11-14,19 |
| A | KR 10-2412606 B1 (LEE, Joong Hui) 22 June 2022 (2022-06-22) claims 1, 3-6, 8-10; and figures 1-6. | 1-20 |
| A | KR 10-2021-0090687 A (CONTEMPORARY AMPEREX TECHNOLOGY CO., LIMITED) 20 July 2021 (2021-07-20) claims 1-13; and figures 1-10. | 1-20 |

✓ Further documents are listed in the continuation of Box C.   ✓ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **04 June 2025** | **04 June 2025** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2025/002967**

| C. | DOCUMENTS CONSIDERED TO BE RELEVANT | |
|---|---|---|
| Category* | Citation of document, with indication, where appropriate, of the relevant passages | Relevant to claim No. |
| A | KR 10-2023-0161073 A (LG ENERGY SOLUTION, LTD.) 27 November 2023 (2023-11-27) claims 1-15; and figures 1-11. | 1-20 |

International application No.

**PCT/KR2025/002967**

| Patent document cited in search report | | | Publication date (day/month/year) | Patent family member(s) | | | Publication date (day/month/year) |
|---|---|---|---|---|---|---|---|
| KR | 10-2023-0157549 | A | 17 November 2023 | KR | 10-2617005 | B1 | 22 December 2023 |
| KR | 10-2015-0120697 | A | 28 October 2015 | KR | 10-2205293 | B1 | 20 January 2021 |
| | | | | US | 10345390 | B2 | 09 July 2019 |
| | | | | US | 2015-0301122 | A1 | 22 October 2015 |
| | | | | US | 2019-0285704 | A1 | 19 September 2019 |
| KR | 10-2412606 | B1 | 22 June 2022 | | None | | |
| KR | 10-2021-0090687 | A | 20 July 2021 | CN | 110967631 | A | 07 April 2020 |
| | | | | CN | 110967631 | B | 30 March 2021 |
| | | | | EP | 3786655 | A1 | 03 March 2021 |
| | | | | EP | 3786655 | A4 | 06 October 2021 |
| | | | | EP | 3786655 | B1 | 20 July 2022 |
| | | | | JP | 2022-511928 | A | 01 February 2022 |
| | | | | JP | 7262588 | B2 | 21 April 2023 |
| | | | | KR | 10-2550936 | B1 | 03 July 2023 |
| | | | | US | 11047918 | B2 | 29 June 2021 |
| | | | | US | 2021-0116513 | A1 | 22 April 2021 |
| | | | | WO | 2020-233326 | A1 | 26 November 2020 |
| KR | 10-2023-0161073 | A | 27 November 2023 | CN | 118891534 | A | 01 November 2024 |
| | | | | EP | 4481416 | A1 | 25 December 2024 |
| | | | | JP | 2025-504648 | A | 14 February 2025 |
| | | | | WO | 2023-224368 | A1 | 23 November 2023 |

Form PCT/ISA/210 (patent family annex) (July 2022)

**EP 4 764 529 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240142672
- KR 1020240066780